# EUROPÄISCHE PATENTANMELDUNG

(11) **EP 2 091 085 A2**
(43) Veröffentlichungstag der Anmeldung: **19.08.2009**
(21) Anmeldenummer: 08021772.2
(22) Anmeldetag: 16.12.2008
(51) Int. Cl.: H01L 31/0224, H01L 31/0392, H01L 31/052

(54) **Photovoltaisches Modul und Verfahren zu dessen Herstellung**

(30) Priorität: 12.02.2008 DE 102008008726
(71) Anmelder: SCHOTT Solar GmbH, 63755 Alzenau (DE)
(72) Erfinder: Lechner, Peter, 85591 Vaterstertten (DE)
(74) Vertreter: Berngruber, Otto

(57) **Zusammenfassung**

Ein photovoltaisches Modul weist auf einem transparenten Substrat (1) eine transparente Frontelektrodenschicht (2), eine Halbleiterschicht (3) und eine Rückelektrodenschicht (4) auf. Die Rückelektrodenschicht (4) weist eine Silberschicht (7) und zwischen der Silberschicht (7) und der Halbleiterschicht (3) eine Zwischenschicht (5) aus einem dotierten Halbleiter auf. Zwischen der Silberschicht (7) und der Zwischenschicht (5) ist eine Kupferschicht (6) vorgesehen.

## Beschreibung

Die Erfindung bezieht sich auf ein photovoltaisches Modul nach dem Oberbegriff des Anspruchs 1. Sie hat auch ein Verfahren zur Herstellung eines solchen Moduls zum Gegenstand.

Bei photovoltaischen Modulen, die eine Silizium-Halbleiterschicht aufweisen, wird in der Regel als Ausgangsmaterial ein transparentes Substrat, beispielsweise Glas, das mit einer transparenten Frontelektrodenschicht, beispielsweise aus einem transparenten, elektrisch leitenden Metalloxid, beschichtet ist, verwendet. Danach werden die Silizium-Halbleiterschicht und die Rückelektrodenschicht abgeschieden. Dazwischen werden beispielsweise mit einem Laser in den Schichten Trennlinien erzeugt, sodass sich eine integrierte Serienschaltung der einzelnen Solarzellen des Moduls ausbildet. Schließlich wird das Rohmodul mit einem Rückseitenschutz zu einem fertigen Modul laminiert.

Als Rückelektrodenschicht wird üblicherweise eine Doppelschicht verwendet, die aus einer Zwischenschicht und der eigentlichen Metallreflektorschicht besteht.

Die Zwischenschicht stellt einerseits eine Diffusionsbarriere für die Metallreflektorschicht dar, verhindert also, dass Metallatome aus der Rückelektrodenschicht in die Siliziumschicht diffundieren. Durch den gegenüber Silizium und dem Metall der Rückelektrodenschicht unterschiedlichen optischen Brechungsindex n bzw. unterschiedlichen optischen komplexen Brechzahl k gelingt es zum anderen, den Reflexionsgrad an der Grenzschicht Silizium-Metall durch die Zwischenschicht zu erhöhen. Für die Zwischenschicht wird ein stark dotierter Halbleiter, wie Indiumoxid (z. B. mit Zinn dotiertes Indiumoxid, ITO) oder Aluminium-dotiertes Zinkoxid (ZAO) verwendet.

Für die Metallreflektorschicht wird ein im sichtbaren und nahen infraroten (NIR) Lichtspektrum gut reflektierender Metallfilm eingesetzt, wobei Aluminium gut geeignet ist, wegen seines höheren Reflexionsvermögens im nahen Infrarotbereich aber noch besser Silber und auch Gold. Die Dicke der Metallreflektorschicht beträgt in der Regel zwischen 100 und 500 nm. Gold scheidet deshalb als Reflektorschicht in der Regel aus Kostengründen aus. Eine Aluminiumschicht ist zwar mit geringeren Kosten verbunden, jedoch weist sie nur einen mäßigen Reflexionsgrad im nahen Infrarotbereich auf.

Silber weist zwar bei erschwinglichen Kosten einen hohen Reflexionsgrad auf, im Gegensatz zu Aluminium weist eine Silber-Reflektorschicht auf der Zwischenschicht aber nur einer geringe Haftung auf. Eine schlechte Haftung der Silber-Reflektorschicht kann jedoch eine Gefahr für die langfristige Zuverlässigkeit des photovoltaischen Moduls darstellen. Insbesondere nach Eindringen von Feuchtigkeit kann die Reflektorschicht von der Zwischenschicht delaminieren und damit zu einem Versagen der Funktion des photovoltaischen Moduls führen.

Zur Verbesserung der Haftung der Silber-Reflektorschicht wird nach dem Stand der Technik zwischen der Silberschicht und der Zwischenschicht noch eine dünne Schicht aus Titan, Chrom, Nickel, Molybdän, Edelstahl oder Wolfram verwendet.

Diese Haftverbesserungsschichten führen jedoch zu einer signifikanten Verschlechterung des Reflexionsgrades des Schichtsystems mit den Grenzflächen Silizium/Zwischenschicht/Haftverbesserungsschicht/ Reflektorschicht.

Aufgabe der Erfindung ist es daher, für eine Silber-Reflektorschicht eine Haftverbesserungsschicht bereitzustellen, mit der ein hoher Reflexionsgrad erzielt wird.

Dies wird erfindungsgemäß dadurch erreicht, dass zwischen der Silberschicht und der Zwischenschicht aus dem dotierten Halbleiter als Haftverbesserungsschicht eine Kupferschicht vorgesehen ist.

Wie sich herausgestellt hat, weist die erfindungsgemäße Reflektorschicht neben einem hohen Reflexionsgrad von 94 % und mehr, also einem Reflexionsgrad, der dem einer Silberschicht unmittelbar auf der Zwischenschicht sehr nahe kommt, eine hervorragende Haftung an der Halbleiterschicht auf.

Die Silberschicht kann dabei aus reinem Silber oder einer Silberlegierung bestehen; ebenso die Kupferschicht, die neben reinem Kupfer auch aus einer Kupferlegierung bestehen kann.

Das transparente Substrat kann Glas oder ein anderes transparentes Material sein. Die Frontelektrodenschicht besteht vorzugsweise aus einem transparenten elektrisch leitfähigen Metalloxid, beispielsweise dotiertem Zinnoxid, z. B. mit Fluor dotierten Zinnoxid. Die Halbleiterschicht kann z. B. aus amorphem, nanokristallinem, mikrokristallinem oder polykristallinem Silizium bestehen. Ausser Silizium kann sie auch aus einem anderen Halbleiter bestehen, z. B. aus Cadmium/Tellur.

Die Zwischenschicht aus dem dotierten Halbleiter zwischen der Kupferschicht und der Siliziumschicht besteht vorzugsweise aus einem Metalloxid, das mit einem Metall dotiert ist. Das Metalloxid kann Indiumoxid oder Aluminiumoxid sein. Das Metall zum Dotieren des Metalloxids kann beispielsweise Indiumoxid oder Aluminiumoxid sein. So kann beispielsweise Zinn-dotiertes Indiumoxid oder Aluminium-dotiertes Zinkoxid als Zwischenschicht verwendet werden.

Die Schichtdicke der Silberschicht beträgt vorzugsweise 50 bis 500 nm, insbesondere 100 bis 300 nm.

Die Schichtdicke der Kupferschicht kann z. B. 1 bis 50 nm betragen, vorzugsweise wird sie auf 2 bis 20 nm eingestellt. Die Schichtdicke der dotierten Halbleiter-Zwischenschicht kann z. B. 10 bis 300 nm betragen, vorzugsweise liegt sie bei 50 bis 200 nm.

Die Rückseite, also die von der Kupferseite abgewandte Seite der Silberschicht kann mit einer Schutzschicht aus Metall versehen sein, beispielsweise mit einer Schicht aus Nickel oder einer Nickellegierung. Die Schichtdicke der Schutzschicht kann 10 bis 400, insbesondere 50 bis 200 nm betragen.

Zudem kann die Rückseite des Moduls mit einem Rückseitenschutz versehen werden, beispielsweise mit einer Kunststoff- oder einer Glasschicht.

Bei der Herstellung des erfindungsgemäßen photovoltaischen Moduls kann von einem Substrat, beispielsweise einer Glasplatte, ausgegangen werden, die z. B. durch chemische Dampfabscheidung (CVD) mit der Frontelektrodenschicht beschichtet ist. Auf die Frontelektrodenschicht wird danach z. B. die Silizium-Halbleiterschicht beispielsweise durch chemische Dampfabscheidung (CVD) abgeschieden und auf der Silizium-Halbleiterschicht die Rückelektrodenschicht aus der Zwischenschicht, der Kupferschicht und der Silberschicht. Die Rückelektrodenschicht, also die Zwischenschicht, die Kupferschicht und die Silberschicht, können beispielsweise durch Sputtern aufgetragen werden, desgleichen die Metallschicht zum Rückseitenschutz der Silberschicht.

Das photovoltaische Modul besteht vorzugsweise aus mehreren Einzelzellen, die miteinander serienverschaltet sind. Zur Serienverschaltung werden die Frontelektrodenschicht, die Silizium-Halbleiterschicht und die Rückelektrodenschicht beispielsweise mit einem Laser mit Trennlinien versehen.

Nachstehend ist eine Ausführungsform des erfindungsgemäßen photovoltaischen Moduls anhand der Zeichnung beispielhaft näher erläutert.

### Darin zeigen jeweils schematisch und im Schnitt

Figur 1 einen Teil eines photovoltaischen Moduls, und
Figur 2 die Rückelektrodenschicht in vergrößerter Wiedergabe.

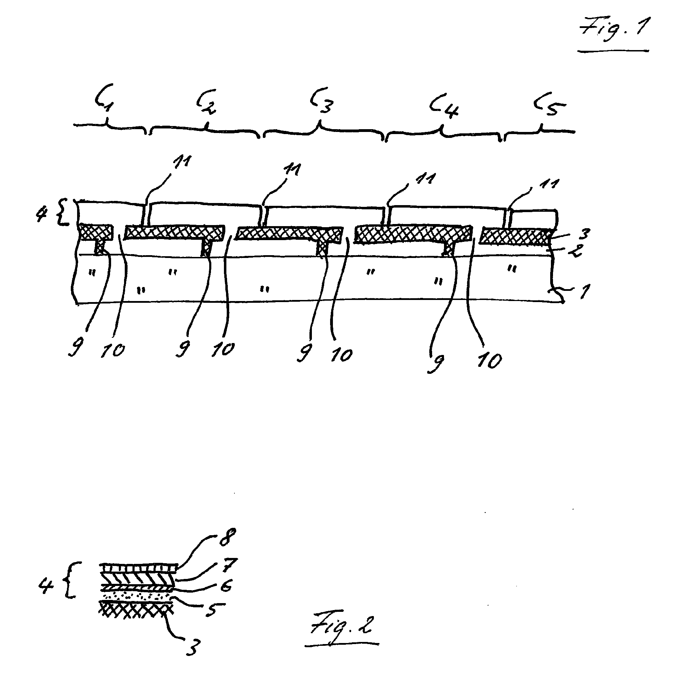

Gemäß Figur 1 ist auf einem großflächigem Substrat 1, beispielsweise einer Glasscheibe, eine Frontelektrodenschicht 2, z. B. aus dotiertem Zinkoxid vorgesehen, auf die eine Halbleiterschicht 3 z. B. aus amorphen Silizium aufgebracht ist. Auf der Silizium-Halbleiterschicht 3 ist die Rückkontaktschicht 4 aufgetragen.

Das Modul besteht aus Einzelzellen C1 bis C5, die serienverschaltet sind. Dazu ist die Frontelektrodenschicht 2 durch die Trennlinien 9, die Silizium-Halbleiterschicht 3 durch die Trennlinien 10 und die Rückelektrodenschicht 4 durch die Trennlinien 11 strukturiert. Die streifenförmigen Einzelzellen C1 bis C5 verlaufen senkrecht zur Stromflussrichtung F.

Gemäß Figur 2 besteht die Rückelektrodenschicht 4 aus der Zwischenschicht 5 aus einem dotiertem Halbleiter, beispielsweise Aluminium-dotiertem Zinkoxid, der Kupferschicht 6 als Haftverbesserungsschicht und der Silberschicht 7 als Reflektorschicht sowie einer Metallschicht 8, beispielsweise einer Nickelschicht, als Schutzschicht.

Die nachstehenden Beispiele dienen der weiteren Erläuterung der Erfindung.

### Beispiel 1

Eine Glasplatte mit einer Frontelektrodenschicht aus einem transparenten Metalloxid und einer Silizium-Halbleiterschicht wurde mit einem Schichtsystem aus einer 100 nm dicken Zinn-dotierten Indiumschicht (ITO), einer 2 nm dicken Kupferschicht (Cu), einer 200 nm dicken Silberschicht und einer 100 nm dicken Nickelschicht (Ni) versehen. Anschließend wurde auf die Rückseite der Probe eine Schutzschicht aus EVA/Tedlar ® aufgebracht.

Es wurde der Reflexionsgrad der Probe bei 650 nm durch Reflexionsmessung von der Glasseite ermittelt, ferner die Haftung der Silberschicht mittels Abzugstest nach einer Feuchte-Hitze-Lagerung (500 Stunden bei 85°C und 85 % relativer Luftfeuchtigkeit) bestimmt.

### Beispiele 2 bis 4

Das Beispiel 1 wurde wiederholt, außer dass eine Kupferschicht mit einer Dicke von 4 bzw. 8 bzw. 12 nm verwendet wurde.

### Vergleichsbeispiel 1

Das Beispiel 1 wurde wiederholt, außer dass die Kupferschicht weggelassen wurde.

### Vergleichsbeispiele 2 und 3

Das Beispiel 1 wurde wiederholt, außer dass anstelle der Kupferschicht eine 2 nm dicke Edelstahlschicht (SS) bzw. eine 200 nm dicke Aluminiumschicht (Al) verwendet wurde.

Die erhaltenen Ergebnisse sind in der nachstehenden Tabelle wiedergegeben.

**Tabelle**

| | | Haftung der Reflektorschicht | Reflexions grad bei 650 nm |
|---|---|---|---|
| Bsp. 1 | 100nm ITO/2nm Cu/200nm Ag/100nm Ni | Gut (+) | 95,5 % |
| Bsp. 2 | 100nm ITO/4nm Cu/200nm Ag/100nm Ni | Gut (+) | 95,3 % |
| Bsp. 3 | 100nm ITO/8nm Cu/200nm Ag/100nm Ni | Gut (+) | 95 % |
| Bsp. 4 | 100nm ITO/12nm Cu/200nm Ag/100nm Ni | Gut (+) | 94,8 % |
| | | | |
| Vgl. Bsp.1 | 100nm ITO/ohne/200nm Ag/100nm Ni | Schlecht (-) | 97 % |
| Vgl. Bsp.2 | 100nm ITO/2nm SS/200nm Ag/100nm Ni | Gut (+) | 88 % |
| Vgl. Bsp.3 | 100nm ITO/200nm Al/100nm Ni | sehr gut (++) | 87 % |

Wie daraus ersichtlich, wurde mit der erfindungsgemäßen Rückelektrodenschicht gemäß den Beispielen 1 bis 4 neben einer guten Haftung der Silberschicht ein hoher Reflexionsgrad von 94,8 % bis 95,5 % ermittelt. Zwar ist der Reflexionsgrad gemäß dem Vergleichsbeispiel 1 bei einer Silberschicht ohne vorgeschalteter Kupferschicht um etwa 1 bis 2 % größer, jedoch die Haftung der Silberschicht schlecht. Demgegenüber wird nach den Vergleichsbeispielen 2 und 3 zwar eine gute bzw. sehr gute Haftung der Silberschicht erhalten, jedoch nur ein geringer Reflexionsgrad von 87 bis 88 % erzielt.

## Patentansprüche

1. Photovoltaisches Modul, das auf einem transparentem Substrat (1) einer transparente Frontelektrodenschicht (2), eine Halbleiterschicht (3) und eine Rückelektrodenschicht (4) aufweist, wobei die Rückelektrodenschicht (4) eine Silberschicht (7) als Reflexionsschicht und zwischen der Silberschicht (7) und der Siliziumschicht (3) eine Zwischenschicht (5) aus einem dotierten Halbleiter aufweist, **dadurch gekennzeichnet, dass** zwischen der Silberschicht (7) und der Zwischenschicht (5) aus den dotierten Halbleitern eine Kupferschicht (6) vorgesehen ist.

2. Photovoltaisches Modul nach Anspruch 1, **dadurch gekennzeichnet, dass** die Schichtdicke der Silberschicht (7) 50 bis 500 nm beträgt.

3. Photovoltaisches Modul nach Anspruch 1, **dadurch gekennzeichnet, dass** die Schichtdicke der Kupferschicht (6) 1 bis 50 nm beträgt.

4. Photovoltaisches Modul nach Anspruch 1, **dadurch gekennzeichnet, dass** die Schichtdicke der Zwischenschicht (5) aus dem dotierten Halbleiter 10 bis 300 nm beträgt.

5. Photovoltaisches Modul nach Anspruch 1, **dadurch gekennzeichnet, dass** der dotierte Halbleiter, aus dem die Zwischenschicht (5) besteht, ein dotiertes Metalloxid ist.

6. Photovoltaisches Modul nach Anspruch 5, **dadurch gekennzeichnet, dass** das Metalloxid mit einem Metall dotiert ist.

7. Photovoltaisches Modul nach Anspruch 5, **dadurch gekennzeichnet, dass** das Metalloxid Indiumoxid oder Zinkoxid ist.

8. Photovoltaisches Modul nach Anspruch 6, **dadurch gekennzeichnet, dass** das Metall Zinn, Gallium, Bor oder Aluminium ist.

9. Photovoltaisches Modul nach Anspruch 1, **dadurch gekennzeichnet, dass** die Silberschicht (7) an ihrer Rückseite mit einer Metallschicht (8) als Schutzschicht versehen ist.

10. Photovoltaisches Modul nach Anspruch 9, **dadurch gekennzeichnet, dass** die Metallschicht (8) eine Nickelschicht ist.

11. Photovoltaisches Modul nach Anspruch 1, **dadurch gekennzeichnet, dass** die Halbleiterschicht (3) aus Silizium besteht.

12. Verfahren zur Herstellung eines photovoltaischen Moduls nach Anspruch 1, **dadurch gekennzeichnet, dass** die Zwischenschicht (5) aus dem dotierten Halbleiter, die Kupferschicht (6) und/oder die Silberschicht (7) durch Sputtern aufgebracht werden.
